# FASCICULE DE BREVET EUROPEEN

(11) **EP 3 679 604 B1**
(45) Date de publication et mention de la délivrance du brevet: **15.02.2023**
(21) Numéro de dépôt: 18773806.7
(22) Date de dépôt: 03.09.2018
(51) Int. Cl.: H01L 25/075, H01L 33/58, H01L 33/62

(54) **PROCEDE DE FABRICATION D'UN DISPOSITIF D'AFFICHAGE EMISSIF A LED**
VERFAHREN ZUR HERSTELLUNG EINER LED-BASIERTEN EMITTIERENDEN ANZEIGEVORRICHTUNG
PROCESS FOR MANUFACTURING AN LED-BASED EMISSIVE DISPLAY DEVICE

(30) Priorité: 05.09.2017 FR 1758189
(43) Date de publication de la demande: 15.07.2020
(73) Titulaire: Commissariat à l'énergie atomique et aux énergies alternatives, 75015 Paris (FR)
(72) Inventeur: ROBIN, Ivan-Christophe, 38000 Grenoble (FR); CAPLET, Stéphane, 38360 Sassenage (FR); ROSSINI, Umberto, 38500 Coublevie (FR)
(74) Mandataire: Cabinet Beaumont
(86) Numéro de dépôt international: PCT/FR2018/052152
(87) Numéro de publication internationale: WO 2019/048767

(56) Documents cités:
- EP-A2- 1 115 155
- WO-A1-2014/030830
- WO-A1-2017/089676
- DE-A1-102013 102 967
- US-A1- 2005 212 406
- US-A1- 2007 145 393
- US-A1- 2017 133 818
- US-A1- 2017 242 160

## Description

### Domaine

La présente demande concerne la réalisation d'un dispositif d'affichage d'images émissif à diodes électroluminescentes (LED), par exemple un écran de télévision, d'ordinateur, de smartphone, de tablette numérique, etc.

### Exposé de l'art antérieur

Il a déjà été proposé, dans la demande de brevet français n°1561421 (DD16594) déposée le 26 novembre 2015 par le demandeur, un dispositif d'affichage d'images comportant une pluralité de puces électroniques élémentaires disposées en matrice sur une même dalle de support. Dans ce dispositif, chaque puce comporte un empilement d'une LED et d'un circuit de commande de la LED, et correspond à un pixel du dispositif. Les puces sont solidaires de la dalle de support et sont connectées à des éléments de connexion électrique de la dalle de support pour leur commande. Dans chaque puce, la LED est formée dans un empilement de couches semiconductrices inorganiques, aussi appelé empilement de LED, par exemple des couches d'un ou plusieurs matériaux semiconducteurs de type III-V, et le circuit de commande est formé dans et sur un substrat de silicium. Le circuit de commande est accolé à une face de l'empilement de LED, la puce étant en contact mécanique et électrique avec la dalle de support par la face du circuit de commande opposée à l'empilement de couches semiconductrices inorganiques.

Il a en outre été proposé, dans la demande de brevet français n°1752953 (DD17709/B15698) déposée le 5 avril 2017 par le demandeur, un dispositif d'affichage du même type, mais dans lequel chaque puce élémentaire comporte une pluralité de LED, le circuit de commande de la puce étant adapté à commander individuellement les différentes LED de la puce.

En particulier, l'une des applications visées par la demande de brevet français n°1752953 (DD17709/B15698) concerne un dispositif d'affichage d'images dit multi-vues, c'est-à-dire dans lequel chaque image à afficher est divisée en une pluralité de macropixels, chaque macropixel comportant une pluralité de pixels correspondant à des vues différentes de la scène que l'on souhaite reproduire. A titre d'exemple, les différents pixels d'un même macropixel correspondent à une même position de pixel respectivement dans différentes images d'une même scène, prises sous des angles de vue différents. Un dispositif d'affichage multi-vues peut par exemple être utilisé dans des applications dans lesquelles on souhaite donner à l'utilisateur une impression de visualisation en trois dimensions.

Dans les dispositifs d'affichage d'images multi-vues décrits dans la demande de brevet français n°1752953 (DD17709/B15698), chaque puce élémentaire correspond à un macropixel du dispositif, comprenant n pixels P1, P2, ... Pn destinés à afficher respectivement un même pixel de n images différentes, correspondant par exemple à n vues différentes d'une même scène, où n est un entier supérieur à 1. Chaque pixel Pi du macropixel, avec i entier allant de 1 à n, peut comprendre plusieurs sous-pixels adaptés à émettre dans des gammes de longueurs d'ondes distinctes, de façon à permettre l'affichage d'images couleur. Ainsi, chaque puce comprend n*m LED, où m est un entier supérieur ou égal à 1 désignant le nombre de sous-pixels par pixel, par exemple égal à trois pour des pixels RGB.

Dans un tel dispositif d'affichage d'images multi-vues, chaque puce élémentaire est en outre surmontée (du côté de la puce opposé à la dalle de support, c'est-à-dire côté LED), d'une lentille adaptée à réaliser la séparation angulaire des faisceaux correspondant aux différents pixels du macropixel, de façon que l'utilisateur perçoive des vues différentes de la scène lorsque son oeil se déplace parallèlement au dispositif d'affichage.

On s'intéresse ici plus particulièrement à la fabrication d'un dispositif d'affichage multi-vues.

US2005/0212406 A1, EP1115155 A2, US2017/0133818 A1 et US2017/0242160 A1 divulguent un dispositif d'affichage à LED, comportant une plaque de support transparente dont une face est plane et dont l'autre face est structurée définissant ainsi une pluralité de microlentilles, et une pluralité de LEDs disposées sur la face plane de la plaque de support. WO2017/089676

A1 divulgue un dispositif d'affichage à LED, comportant une pluralité de puces semi-conductrices, chaque puce comportant un empilement de couches semi-conductrices inorganiques dans lequel est formé une LED et un circuit de commande, chaque circuit de commande comportant une pluralité de bornes de connexion électrique disposées sur la face du circuit de commande opposée à la LED.

### Résumé

Ainsi, l'invention prévoit un procédé de fabrication d'un dispositif d'affichage à LED conformément à la revendication 1.

Selon un mode de réalisation, pendant l'étape a), la plaque de support est éclairée au moyen d'une source lumineuse disposée du côté de sa face structurée, de façon à générer sur sa face plane un motif lumineux utilisé comme marque d'alignement pour le positionnement des puces sur la plaque de support.

Selon un mode de réalisation, le procédé comprend en outre, entre l'étape a) et l'étape b), une étape c) de dépôt d'une couche de résine opaque entre les puces du dispositif.

Selon un mode de réalisation, la couche est une couche de résine photosensible négative, l'étape c) comprenant les étapes successives suivantes :
déposer la couche entre les puces et sur la face des puces opposée à la plaque de support ;
insoler la couche au travers de la plaque de support, les puces servant de masque lors de l'étape d'insolation ; et
développer la résine photosensible.

Selon un mode de réalisation, l'étape c) comprend en outre une étape de recuit de la couche entre l'étape d'insolation et l'étape de développement.

Selon l'invention, chaque puce comprend un empilement de couches semiconductrices inorganiques dans lequel est formée la LED, et un circuit de commande de la LED formé dans et sur un substrat semiconducteur, le circuit de commande étant accolé à une face de l'empilement, et chaque puce étant disposée de façon que la face de l'empilement opposée au circuit de commande soit tournée vers la plaque de support.

Selon un mode de réalisation, chaque puce comprend une pluralité de LED formées dans l'empilement, le circuit de commande étant adapté à commander individuellement les différentes LED de la puce.

Selon l'invention, dans chaque puce, le circuit de commande comprend une pluralité de bornes de connexion électrique disposées sur la face du circuit de commande opposée à l'empilement.

Selon un mode de réalisation, le réseau de pistes conductrices d'interconnexion est en contact avec les bornes de connexion électrique.

Selon un mode de réalisation, le réseau de pistes conductrices d'interconnexion est formé par impression d'un premier niveau conducteur, suivi d'un niveau isolant, suivi d'un deuxième niveau conducteur.

L'invention prévoit également un dispositif d'affichage à LED conformément à la revendication 9.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
les figures 1A, 1B et 1C sont des vues en coupe illustrant de façon schématique des étapes d'un exemple d'un procédé de fabrication d'un dispositif d'affichage émissif à LED multi-vues selon un mode de réalisation ;
la figure 2 est un schéma électrique des circuits d'un exemple d'une puce élémentaire d'un dispositif d'affichage émissif à LED multi-vues selon un mode de réalisation ;
les figures 3A, 3B et 3C sont des vues schématiques respectivement de dessus, en coupe et de dessous d'un exemple d'une puce élémentaire d'un dispositif d'affichage émissif à LED multi-vues selon un mode de réalisation ;
la figure 3D est une vue en perspective illustrant schématiquement un exemple de réalisation d'une plaque de support d'un dispositif d'affichage émissif à LED multi-vues selon un mode de réalisation ;
la figure 4 est une vue de dessus schématique et partielle d'un exemple d'un dispositif d'affichage émissif à LED multi-vues selon un mode de réalisation ; et
la figure 5 est une vue de dessus schématique et partielle d'une variante de réalisation du dispositif de la figure 4.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la réalisation des puces élémentaires des dispositifs d'affichage décrits n'a pas été détaillée, les modes de réalisation décrits étant compatibles avec les réalisations usuelles de telles puces. A titre d'exemple, les puces élémentaires peuvent être fabriquées selon des procédés identiques ou similaires à ceux décrits dans les demandes de brevet français n°1561421 (DD16594) et n°1752953 (DD17709/B15698) susmentionnées. Dans la description qui suit, lorsque l'on fait référence à des qualificatifs de position relative, tels que les termes "dessus", "dessous", "supérieur", "inférieur", etc., ou à des qualificatifs d'orientation, tels que les termes "horizontal", "vertical", etc., il est fait référence à l'orientation des vues en coupe des figures, étant entendu que, dans la pratique, les dispositifs décrits peuvent être orientés différemment. Sauf précision contraire, les expressions "approximativement", "sensiblement", et "de l'ordre de" signifient à 10 % près, de préférence à 5 % près, ou, lorsqu'ils se rapportent à des dimensions ou orientations angulaires, à 10 degrés près, de préférence à 5 degrés près.

Selon un aspect d'un mode de réalisation, on prévoit un procédé de fabrication d'un dispositif d'affichage multi-vues dans lequel, plutôt que de reporter les puces élémentaires correspondant aux macropixels du dispositif sur une dalle de support comprenant des éléments de connexion électrique, puis de disposer des microlentilles au-dessus des macropixels, on vient reporter les puces élémentaires directement sur une plaque de support transparente intégrant des microlentilles, puis on réalise des éléments de connexion électrique contactant les puces par leur face opposée à la plaque de support. Autrement dit, on se sert ici de la plaque de microlentilles comme support pour les puces élémentaires et pour les éléments de connexion électrique du dispositif d'affichage, ce qui permet de se passer d'une dalle de support spécifiquement prévue à cet effet. On peut ainsi réaliser un dispositif d'affichage particulièrement mince (éventuellement flexible) et peu coûteux.

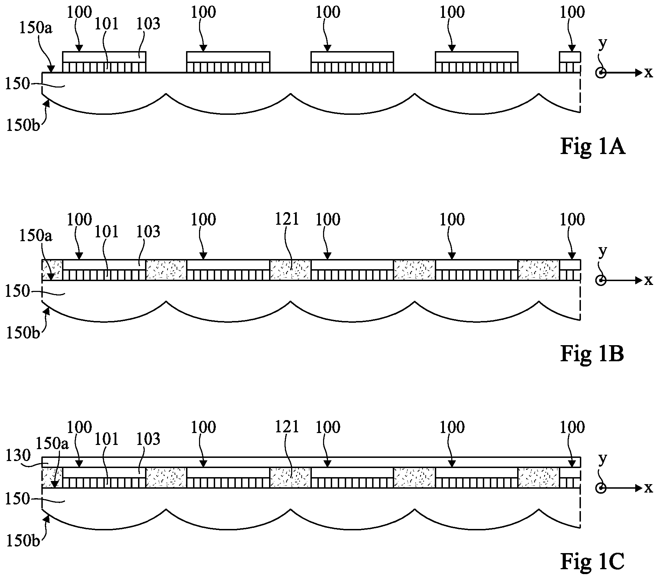

Les figures 1A, 1B et 1C sont des vues en coupe illustrant de façon schématique des étapes successives d'un exemple d'un procédé de fabrication d'un dispositif d'affichage émissif à LED multi-vues selon un mode de réalisation.

La figure 1A illustre une étape de report des puces élémentaires 100 du dispositif d'affichage sur une plaque de support 150.

Chaque puce élémentaire 100 comprend un empilement 101 de couches semiconductrices inorganiques, aussi appelé empilement de LED, par exemple des couches d'un ou plusieurs matériaux semiconducteurs de type III-V, par exemple des couches de nitrure de gallium. Chaque puce 100 comprend une pluralité de LED (non détaillées sur les figures 1A à 1C) formées dans l'empilement 101, correspondant respectivement aux différents sous-pixels du macropixel. Chaque puce 100 comprend en outre, accolé à une face de l'empilement de LED 101, un circuit de commande 103 formé dans et sur un substrat semiconducteur, par exemple en silicium. Le circuit de commande 103 est connecté électriquement à l'empilement de LED 101, et est adapté à commander individuellement les différentes LED de l'empilement de LED 101. La face de l'empilement de LED 101 opposée au circuit de commande 103 définit la face d'émission lumineuse de la puce. La face du circuit de commande 103 opposée à l'empilement de LED 101 définit la face de connexion électrique de la puce, et comprend une pluralité de bornes de connexion (non détaillées sur les figures 1A à 1C) de la puce à un dispositif extérieur.

La plaque de support 150 est une plaque en un matériau transparent, par exemple du verre ou du plastique, dont une face 150a (la face supérieure dans l'exemple représenté) est sensiblement plane, et dont une face 150b (la face inférieure dans l'exemple représenté) opposée à la face 150a présente des structurations, par exemple de forme convexe, définissant une pluralité de microlentilles

Les puces élémentaires 100 sont reportées sur la plaque de support 150, du côté de sa face plane 150a, de façon que la face d'émission lumineuse de chaque puce 100 soit tournée vers la plaque de support. Une couche de colle transparente (non détaillée sur les figures) peut être prévue à l'interface entre la face d'émission lumineuse de chaque puce 100 et la face plane 150a de la plaque de support 150, pour fixer les puces sur la plaque de support.

A l'étape de la figure 1A, les puces élémentaires 100 doivent de préférence être positionnées selon un alignement relativement précis par rapport aux axes optiques des microlentilles formées dans la plaque support 150. Pour réaliser cet alignement, on peut prévoir, pendant l'étape de report des puces 100 sur la plaque de support 150, d'éclairer la plaque 150 au moyen d'une source lumineuse (non visible sur la figure) disposée du côté de sa face 150b, de façon à générer sur la face 150a de la plaque 150 un motif lumineux pouvant servant de marque d'alignement pour le positionnement des puces 100. A titre d'exemple, la source lumineuse est une source ponctuelle, par exemple positionnée en vis-à-vis du centre de la plaque de support 150, à une distance de la plaque de support 150 correspondant à la distance nominale de visualisation du dispositif. La lumière est alors focalisée par les microlentilles, générant sur la face 150a de la plaque 150 un motif lumineux pouvant servir de marque d'alignement pour le positionnement des puces 100. Plus généralement, toute autre méthode d'alignement connue pourra être utilisée lors de cette étape.

La figure 1B illustre une étape optionnelle de dépôt d'une couche 121 de résine opaque, par exemple une couche de résine noire, entre les puces élémentaires 100 du dispositif d'affichage, notamment pour éviter des réflexions parasites de lumière provenant de l'extérieur du dispositif d'affichage, sur les pistes conductrices d'interconnexion qui seront disposées ultérieurement (étape de la figure 1C) du côté des puces 100 opposé à la plaque de support 150. La prévision d'une couche 121 en résine noire permet en particulier d'augmenter le contraste lorsque le dispositif d'affichage est utilisé avec une lumière ambiante non nulle.

A titre d'exemple, la couche 121 est une couche de résine photosensible négative. La couche 121 est par exemple déposée sur toute la surface supérieure de l'assemblage obtenu à l'issue de l'étape de la figure 1A, c'est-à-dire sur la face de connexion des puces 100, ainsi que sur la face 150a de la plaque de support 150 entre les puces 100. La couche 121 est ensuite insolée au travers des microlentilles, c'est-à-dire au moyen d'une source d'irradiation disposée du côté de la face 150b de la plaque de support 150, par exemple une source diffuse étendue. Les puces élémentaires 100 servent de masque lors de l'étape d'insolation. Autrement dit, l'étape d'insolation conduit à initier la polymérisation de la résine dans les zones de la couche 121 situées entre les puces élémentaires 100 du dispositif (et donc non masquées par les puces élémentaires 100), mais pas dans les zones de la couche 121 surmontant les puces élémentaires 100 (et donc masquées par les puces élémentaires 100). Après l'étape d'insolation, un recuit peut être prévu pour augmenter la polymérisation de la résine dans les zones insolées. Une étape de développement peut ensuite être prévue pour retirer la résine dans les zones où elle n'a pas été polymérisée, tout en la conservant dans les zones polymérisées. Autrement dit, la couche 121 est conservée entre les puces élémentaires 100 du dispositif, mais retirée au-dessus des puces élémentaires de façon à libérer l'accès à la face de connexion de chaque puce.

La figure 1C illustre une étape de formation d'un réseau 130 de pistes conductrices d'interconnexion sur la face supérieure du dispositif obtenu à l'issue des étapes des figures 1A et 1B, c'est-à-dire du côté des puces 100 opposé à la plaque de support 150. Le réseau d'interconnexion 130 connecte les puces élémentaires 100 du dispositif d'affichage entre elles et à un circuit de commande externe (non représenté). Le réseau d'interconnexion 130 comprend une alternance de niveaux conducteurs et isolants (non détaillés sur la figure 1C), par exemple au moins deux niveaux conducteurs séparés par un niveau isolant, formés par un procédé d'impression de type impression jet d'encre, sérigraphie, rotogravure, ou par toute autre méthode adaptée.

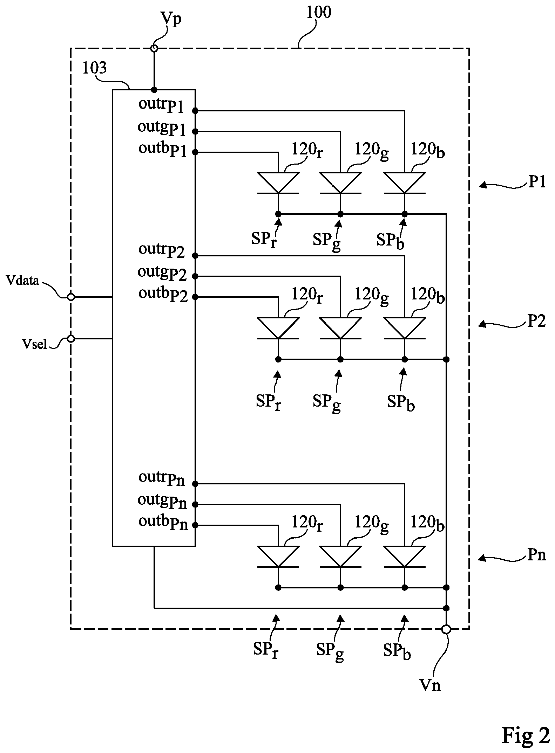

Les figures 2, 3A à 3C et 4 illustrent des exemples de réalisation des puces élémentaires 100 et du réseau d'interconnexion 130 du dispositif d'affichage.

La figure 2 est un schéma électrique simplifié des circuits d'un exemple d'une puce élémentaire 100 d'un dispositif d'affichage émissif à LED multi-vues selon un mode de réalisation.

Dans cet exemple, chaque puce élémentaire 100 correspond à un macropixel du dispositif, comprenant n pixels P1, P2, ... Pn, chaque pixel Pi comprenant trois sous-pixels SPᵣ, SP_{g} et SP_{b} adaptés à émettre respectivement de la lumière rouge, de la lumière verte et de la lumière bleue.

Pour chaque sous-pixel SPᵣ, SP_{g}, SP_{b}, la puce 100 comprend une LED 120ᵣ, respectivement 120_{g}, respectivement 120_{b}, formée dans l'empilement de LED 101 de la puce. Les LED 120ᵣ 120_{g} et 120_{b} sont par exemple des LED de natures distinctes adaptées à émettre de la lumière dans des gammes de longueurs d'ondes distinctes. A titre de variante, les LED 120ᵣ 120_{g} et 120_{b} sont de même nature et émettent dans la même gamme de longueurs d'onde, mais sont surmontées de filtres ou d'élément de conversion photoluminescents de natures distinctes de façon que les pixels SPᵣ, SP_{g} et SP_{b} émettent dans des gammes de longueurs d'onde distinctes.

La puce 100 comprend en outre un circuit de commande 103 adapté à commander individuellement l'intensité du rayonnement lumineux émis par chacune des LED de la puce. Dans cet exemple, le circuit de commande 103 comprend quatre bornes de connexion à l'extérieur Vp, Vn, Vsel, et Vdata, disposées sur la face de connexion de la puce, c'est-à-dire sur la face du circuit de commande 103 opposée à l'empilement de LED 101. Par souci de simplification, les signaux électriques appliqués sur les bornes de connexion des puces sont désignés par les mêmes références que les bornes elles-mêmes. Les bornes Vp et Vn sont destinées à recevoir respectivement un potentiel d'alimentation bas Vp (par exemple la masse) et un potentiel d'alimentation haut (c'est-à-dire supérieur au potentiel d'alimentation bas) Vn de la puce. Les bornes Vsel et Vdata sont destinées à recevoir des signaux de commande de la puce. Plus particulièrement, le signal Vsel est un signal de sélection de la puce, et le signal Vdata est un signal de réglage des niveaux de luminosité des différentes LED de la puce.

Dans cet exemple, et comme cela a été décrit dans la demande de brevet français n°1752953 (DD17709/B15698) susmentionnée, lors d'une phase de mise à jour des n*m sous-pixels de la puce (m=3 dans cet exemple), les n*m signaux individuels de réglages des n*m LED de la puce sont multiplexés temporellement sur la borne Vdata. Autrement dit, chaque puce 100 comprend une unique borne de connexion à l'extérieur pour recevoir les n*m signaux individuels de réglage de luminosité des différentes LED de la puce. Ainsi, dans l'exemple de la figure 2, chaque puce élémentaire 100 comprend seulement quatre bornes de connexion à l'extérieur, c'est-à-dire pas plus que dans une puce élémentaire du type décrit dans la demande de brevet français n°1561421 (DD16594) susmentionnée, comprenant une seule LED. Ceci permet avantageusement de limiter le nombre et la densité des éléments de connexion électrique à prévoir dans le réseau d'interconnexion 130 (figure 1C) reliant les puces élémentaires 100 à un circuit de commande externe.

Le circuit de commande 103 de la puce est adapté à démultiplexer les signaux reçus sur la borne Vdata et à appliquer à chaque LED de la puce 100 un signal de polarisation fonction du signal de réglage individuel de la LED reçu sur la borne Vdata. Pour cela, le circuit de commande 103 comprend n*m noeuds de sortie reliés respectivement aux régions de contact d'anode des n*m LED de la puce. Plus particulièrement, dans cet exemple, le circuit 103 comprend, pour chaque pixel Pi de la puce, un noeud de sortie outr_{Pi} relié à l'anode de la LED 120ᵣ du pixel Pi, un noeud de sortie outg_{Pi} relié à l'anode de la LED 120_{g} du pixel Pi, et un noeud de sortie outb_{Pi} relié à l'anode de la LED 120_{b} du pixel Pi. Le circuit 103 est par exemple adapté à fournir à chaque LED de la puce, via son noeud de sortie correspondant, un courant de polarisation fonction du signal de réglage individuel de la LED reçu sur la borne Vdata de la puce. Dans cet exemple, chacune des LED 120ᵣ, 120_{g}, 120_{b} de la puce a sa cathode connectée à la borne Vn.

Le signal de réglage Vdata reçu par la puce 100 peut être un signal analogique ou un signal numérique sérialisé, la réalisation des circuits de décodage (ou démultiplexage) du signal Vdata pouvant être adaptée en conséquence. Pour faciliter le décodage du signal Vdata par le circuit de commande 103, un signal de synchronisation ou un signal d'horloge peut être appliqué sur la borne Vsel de la puce. A titre de variante, la puce peut comprendre une borne de connexion spécifique supplémentaire (non représentée) pour appliquer le signal d'horloge ou de synchronisation.

A titre d'exemple, les puces élémentaires 100 du dispositif d'affichage sont disposées en matrice selon des lignes et des colonnes sur la plaque de support 150 (figures 1A à 1C) . Les puces élémentaires 100 du dispositif sont par exemple commandables simultanément ligne par ligne. Autrement dit, pour chaque ligne de la matrice, les puces de la ligne ont leurs bornes de commande Vsel connectées à une même piste conductrice de commande de ligne du réseau d'interconnexion 130 (figure 1C), les puces de lignes distinctes ayant leurs bornes de commande Vsel connectées à des pistes conductrices de commande de ligne distinctes du réseau d'interconnexion. De plus, pour chaque colonne de la matrice, les puces de la colonne ont leurs bornes de commande Vdata connectées à une même piste conductrice de commande de colonne du réseau d'interconnexion, les puces de colonnes distinctes ayant leurs bornes de commande Vdata connectées à des pistes conductrices de commande de colonne distinctes du réseau d'interconnexion. Lors de l'affichage d'une image, les macropixels du dispositif peuvent ainsi être rafraîchis simultanément ligne par ligne.

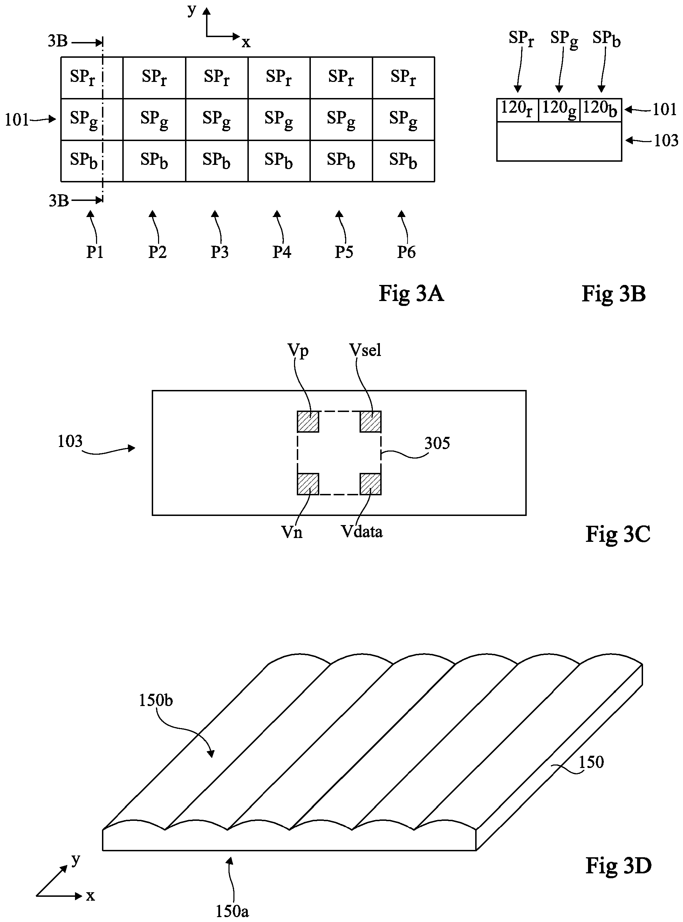

Les figures 3A, 3B et 3C sont des vues schématiques d'une puce élémentaire 100 d'un dispositif d'affichage d'images du type décrit ci-dessus. Dans cet exemple, la puce 100 comprend six pixels P1, P2, P3, P4, P5 et P6 comprenant chacun trois sous-pixels SPᵣ, SP_{g} et SP_{b} adaptés à émettre dans trois gammes de longueurs d'ondes distinctes.

La figure 3A est une vue de dessus (côté face d'émission lumineuse) de la puce, la figure 3B est une vue en coupe de la puce selon le plan 3B-3B de la figure 3A, et la figure 3C est une vue de dessous (côté face de connexion) de la puce.

Comme représenté sur la figure 3C, la puce comprend, du côté de la face du circuit de commande 103 opposée à l'empilement de LED 101, une zone de connexion électrique 305 comprenant les quatre bornes de connexion à l'extérieur Vp, Vn, Vsel et Vdata de la puce.

On notera que dans l'exemple représenté, comme cela apparaît sur la figure 3A, les pixels P1, P2, ... Pn de la puce sont disposés en barrette, alignés selon un axe x. Les puces élémentaires sont montées sur la plaque de support 150 (figures 1A à 1C) du dispositif selon un agencement matriciel en lignes et en colonnes, de façon que l'axe x de chaque puce soit sensiblement parallèle aux lignes de la matrice. Dans chaque pixel Pi, les sous-pixels SPᵣ, SP_{g}, SP_{b} du pixel sont en revanche disposés en barrette, alignés selon un axe y sensiblement orthogonal à l'axe x, et sensiblement parallèle aux colonnes de la matrice de macropixels. En effet, dans un dispositif d'affichage multi-vues, on cherche généralement à ce que l'utilisateur puisse percevoir des vues différentes de la scène lorsque l'oeil de l'observateur se déplace selon une direction parallèle à l'axe des lignes de la matrice (généralement une direction horizontale), et non lorsqu'il se déplace selon une direction parallèle à l'axe des colonnes (généralement une direction verticale). Dans cet exemple, les microlentilles de la plaque support 150 sont adaptées à réaliser une séparation angulaire, selon l'axe x, des faisceaux correspondant aux différents pixels du macropixel, sans réaliser de séparation angulaire selon l'axe y. A titre d'exemple, les microlentilles ont, vu de face, la forme de bandes sensiblement parallèles aux colonnes de la matrice, chaque bande ayant une section transversale (selon l'axe x) convexe et une section longitudinale (selon l'axe y) sensiblement rectiligne, comme illustré schématiquement sur la vue en perspective de la plaque de support 150 de la figure 3D (voir aussi les axes x et y représentés sur les figures 1A, 1B et 1C). Un avantage de cette configuration est qu'elle permet d'éviter une séparation angulaire des différentes couleurs d'un même pixel par les microlentilles.

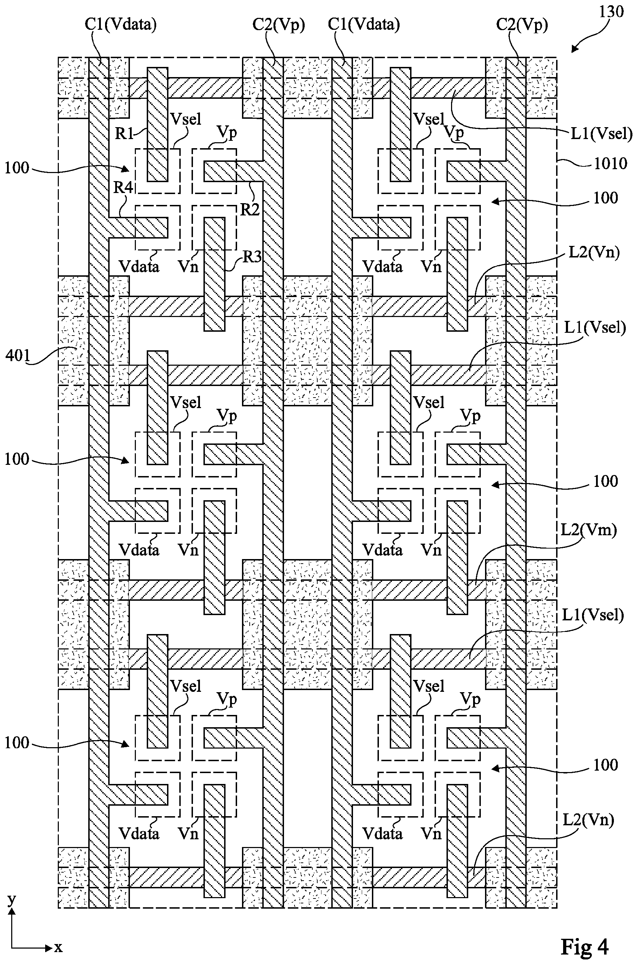

La figure 4 est une vue de dessus d'un exemple d'un dispositif d'affichage émissif à LED multi-vues du type décrit ci-dessus, illustrant plus particulièrement un exemple de réalisation du réseau d'interconnexion 130 (figure 1C) du dispositif d'affichage.

Sur la figure 4, seule une portion du dispositif d'affichage, correspondant à une sous-matrice de trois lignes par deux colonnes du dispositif (soit 3*2=6 puces élémentaires, c'est-à-dire 6 macropixels, soit 6*n pixels donc 6*n*m sous-pixels), a été représentée. Pour plus de clarté, seul le réseau d'interconnexion 130, ainsi que les bornes de connexion électrique Vp, Vn, Vsel et Vdata de chaque puce élémentaire 100, ont été détaillés sur la figure 4. En particulier, le contour des puces 100, la couche de résine opaque 121 et la plaque de support 150 du dispositif ne sont pas visibles sur la figure 4.

Le réseau d'interconnexion 130 comprend des éléments de connexion électrique, et en particulier des pistes conductrices, formés sur la face supérieure de l'assemblage obtenu à l'issue des étapes des figures 1A et 1B. Ces éléments de connexion électrique sont formés par dépôt d'une succession de niveaux conducteurs et isolants sur la face supérieure de l'assemblage. Les éléments de connexion électrique sont par exemple formés par un procédé d'impression de type impression jet d'encre, sérigraphie, rotogravure, ou par toute autre méthode d'impression adaptée.

Des circuits actifs (non représentés) de commande du dispositif d'affichage, adaptés à alimenter et commander les puces élémentaires du dispositif par l'intermédiaire des éléments de connexion électrique du réseau d'interconnexion 130, sont par exemple connectés aux éléments de connexion électrique du réseau d'interconnexion 130 à la périphérie du dispositif d'affichage.

Dans l'exemple représenté, la fabrication du réseau d'interconnexion 130 comprend les trois étapes successives d'impression suivantes.

Lors d'une première étape d'impression, on imprime, sur la face supérieure du dispositif obtenu à l'issue des étapes des figures 1A et 1B, une pluralité de pistes conductrices sensiblement parallèles à la direction des lignes du dispositif d'affichage. Plus particulièrement, dans cet exemple, lors de la première étape d'impression, on imprime, pour chaque ligne du dispositif d'affichage, deux pistes conductrices L1 et L2 s'étendant sur sensiblement toute la longueur des lignes du dispositif d'affichage. Les pistes L1 sont destinées à véhiculer les signaux de commande Vsel des différentes lignes de macropixels du dispositif. Les pistes L2 sont destinées à distribuer le potentiel d'alimentation bas Vn du dispositif. Les éléments conducteurs imprimés lors de cette première étape d'impression définissent un premier niveau conducteur M1 du réseau d'interconnexion.

Lors d'une deuxième étape d'impression, on recouvre certaines portions des pistes conductrices L1 et L2 d'un matériau isolant 401, de façon à permettre l'impression ultérieure de pistes conductrices s'étendant au-dessus des pistes L1 et L2, sans créer de court-circuit avec les pistes L1 et L2.

Lors d'une troisième étape d'impression, on imprime sur la face supérieure de l'assemblage une pluralité de pistes conductrices sensiblement parallèles à la direction des colonnes du dispositif d'affichage. Plus particulièrement, dans cet exemple, lors de la troisième étape d'impression, on imprime, pour chaque colonne du dispositif d'affichage, deux pistes conductrices C1 et C2 s'étendant sur sensiblement toute la longueur des colonnes du dispositif d'affichage. Les pistes C1 sont destinées à véhiculer les signaux de commande Vdata des différentes colonnes de pixels ou de macropixels du dispositif. Les pistes C2 sont destinées à distribuer le potentiel d'alimentation haut Vp du dispositif. Les pistes conductrices C1 et C2 sont isolées des pistes conductrices L1 et L2 par les régions isolantes 401 formées à l'étape précédente.

Lors de la troisième étape d'impression, sont en outre imprimées, pour chaque puce élémentaire 100 du dispositif, quatre portions de pistes conductrices R1, R2, R3 et R4 reliant respectivement la borne Vsel de la puce à la piste conductrice L1 de la ligne comprenant la puce, la borne Vp de la puce à la piste conductrice C2 de la colonne comprenant la puce, la borne Vp de la puce à la piste conductrice L2 de la ligne comprenant la puce, et la borne Vdata de la puce à la piste conductrice C1 de la colonne comprenant la puce.

A titre de variante, et selon l'agencement des bornes de connexion électrique Vsel, Vp, Vdata et Vn des puces élémentaires, les pistes conductrices C1 et C2 peuvent passer directement sur et en contact avec les bornes de connexion Vdata et Vp respectivement, auquel cas les portions de pistes conductrices R2 et R4 peuvent être omises.

Les pistes et portions de pistes conductrices imprimées lors de la troisième étape définissent un deuxième niveau conducteur M2 du réseau d'interconnexion.

Un avantage du réseau d'interconnexion 130 décrit en relation avec la figure 4 est que toutes les pistes ou portions de pistes conductrices connectées directement aux bornes de connexion des puces élémentaires (les éléments R1, R2, R3 et R4 dans l'exemple représenté) sont formées dans un même niveau conducteur, lors d'une même étape d'impression, ce qui permet un positionnement relativement précis de ces éléments de connexion les uns par rapport aux autres. En effet, la résolution d'impression des motifs conducteurs lors d'une même étape d'impression est relativement élevée, tandis qu'il peut exister une erreur d'alignement relativement importante entre des motifs conducteurs formés lors d'étapes d'impression différentes. A titre d'exemple, un réseau d'interconnexion du type décrit en relation avec la figure 4 est compatible avec une distance minimale de l'ordre de 20 µm entre deux bornes de contact d'une même puce élémentaire, ce qui est tout à fait satisfaisant compte tenu des dimensions relativement importantes, typiquement de plusieurs centaines de micromètres, des puces élémentaires.

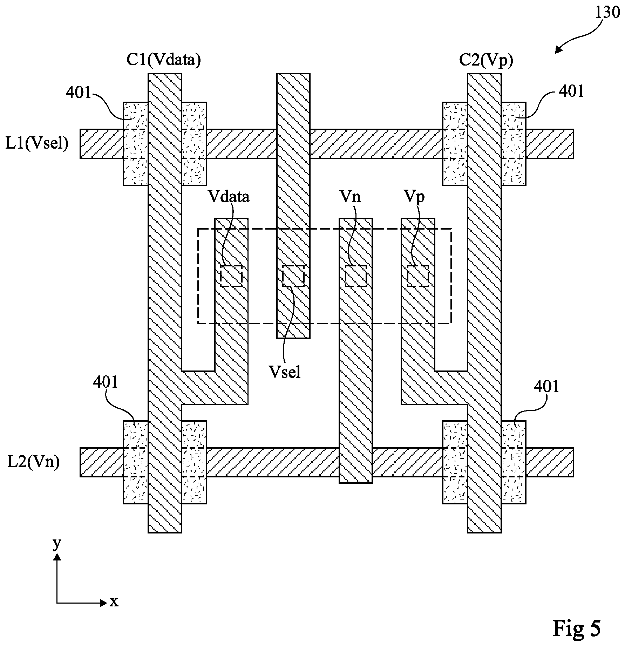

La figure 5 est une vue de dessus d'une variante de réalisation du dispositif de la figure 4.

Sur la figure 5, seule une portion du dispositif d'affichage, correspondant à un unique macropixel du dispositif, a été représentée. Pour plus de clarté, seul le réseau d'interconnexion 130, ainsi que les bornes de connexion électrique Vp, Vn, Vsel et Vdata de chaque puce élémentaire 100, ont été détaillés sur la figure 5.

La variante de la figure 5 diffère de l'exemple de la figure 4 principalement en ce que, dans cette variante, les bornes de contact Vdata, Vsel, Vp et Vn de chaque puce élémentaire sont alignées, ce qui permet, dans le cas d'une technologie d'impression à rouleau, de bénéficier de la résolution maximale de la technique d'impression dans la mesure où, dans la zone critique d'impression (la zone de reprise de contact), les motifs conducteurs imprimés sont des lignes parallèles orientées selon l'axe d'impression (l'axe y dans l'exemple représenté).

Des modes de réalisation particuliers ont été décrits. Diverses variantes et modifications apparaîtront à l'homme de l'art. En particulier, bien que l'on ait décrit uniquement des exemples de réalisation dans lesquels chaque puce élémentaire du dispositif d'affichage comprend quatre bornes de connexion à l'extérieur, le procédé décrit en relation avec les figures 1A à 1C peut être adapté à la fabrication d'un dispositif d'affichage dans lequel chaque puce élémentaire comprend un nombre de bornes de connexion à l'extérieur différent de quatre.

De plus, les modes de réalisation décrits ne se limitent pas aux exemples décrits ci-dessus dans lequel chaque pixel d'un macropixel comprend plusieurs sous-pixels adaptés à émettre dans des gammes de longueurs d'ondes distinctes. A titre de variante, les exemples décrits ci-dessus peuvent être adaptés au cas où les pixels P1, P2, ... Pn de chaque puce élémentaire 100 du dispositif sont des pixels monochromatiques, par exemple comportant une seule LED.

En outre, bien que l'on ait décrit uniquement des exemples d'application du procédé des figures 1A à 1C à la fabrication d'un dispositif d'affichage multi-vues, les modes de réalisation ne se limitent pas à cette application particulière.

Plus généralement, le procédé des figures 1A à 1C peut être adapté à la réalisation de tout dispositif d'affichage émissif à LED dans lequel on souhaite disposer des microlentilles en vis-à-vis des puces élémentaires du dispositif.

A titre d'exemple, chaque puce élémentaire du dispositif d'affichage peut correspondre à un pixel unique, par exemple un pixel monochromatique (la puce comprenant alors une unique LED), ou un pixel couleur (la puce comprenant alors plusieurs sous-pixels comprenant chacun une LED) . Dans ce cas, les microlentilles de la plaque de support 150 ont par exemple pour fonction d'augmenter la directivité du dispositif d'affichage, et non plus d'assurer une séparation angulaire des différents faisceaux émis par chaque puce.

On notera de plus que dans les exemples des figures 4 et 5, l'agencement ligne/colonne des connexions aux bornes Vsel, Vn, Vp et Vdata des puces élémentaires peut être différent de ce qui a été représenté.

## Revendications

1. Procédé de fabrication d'un dispositif d'affichage à LED, comportant les étapes successives suivantes :
a) reporter, sur une face plane d'une plaque de support (150) en un matériau transparent dont l'autre face est structurée et définit une pluralité de microlentilles, une pluralité de puces semiconductrices (100) comprenant chacune au moins une LED (120ᵣ, 120_{g}, 120_{b}) ; et
b) former un réseau (130) de pistes conductrices d'interconnexion contactant les puces (100) par leur face opposée à la plaque de support (150)
dans lequel chaque puce (100) comprend un empilement de couches semiconductrices inorganiques (101) dans lequel est formée ladite au moins une LED (120ᵣ, 120_{g}, 120_{b}), et un circuit de commande (103) de ladite au moins une LED formé dans et sur un substrat semiconducteur, le circuit de commande (103) étant accolé à une face de l'empilement (101), et chaque puce (100) étant disposée de façon que la face de l'empilement (101) opposée au circuit de commande (103) soit tournée vers la plaque de support (150),
et dans lequel, dans chaque puce (100), le circuit de commande comprend une pluralité de bornes de connexion électrique (Vp, Vn, Vdata, Vsel) disposées sur la face du circuit de commande (103) opposée à l'empilement (101).

2. Procédé selon la revendication 1, dans lequel, pendant l'étape a), la plaque de support (150) est éclairée au moyen d'une source lumineuse disposée du côté de sa face structurée (150b), de façon à générer sur sa face plane (150a) un motif lumineux utilisé comme marque d'alignement pour le positionnement des puces (100) sur la plaque de support (150).

3. Procédé selon la revendication 1 ou 2, comprenant en outre, entre l'étape a) et l'étape b), une étape c) de dépôt d'une couche (121) de résine opaque entre les puces (100) du dispositif.

4. Procédé selon la revendication 3, dans lequel ladite couche (121) est une couche de résine photosensible négative, l'étape c) comprenant les étapes successives suivantes :
déposer ladite couche (121) entre les puces (100) et sur la face des puces (100) opposée à la plaque de support (150) ;
insoler ladite couche (121) au travers de la plaque de support (150), les puces (100) servant de masque lors de l'étape d'insolation ; et
développer la résine photosensible.

5. Procédé selon la revendication 4, dans lequel l'étape c) comprend en outre une étape de recuit de ladite couche (121) entre l'étape d'insolation et l'étape de développement.

6. Procédé selon l'une quelconque des revendications 1 à 5, dans lequel chaque puce (100) comprend une pluralité de LED formées dans ledit empilement (101), le circuit de commande (103) étant adapté à commander individuellement les différentes LED de la puce.

7. Procédé selon l'une quelconque des revendications 1 à 6, dans lequel le réseau (130) de pistes conductrices d'interconnexion est en contact avec lesdites bornes de connexion électrique (Vp, Vn, Vdata, Vsel).

8. Procédé selon la revendication 7, dans lequel le réseau (130) de pistes conductrices d'interconnexion est formé par impression d'un premier niveau conducteur, suivi d'un niveau isolant, suivi d'un deuxième niveau conducteur.

9. Dispositif d'affichage à LED, comportant :
une plaque de support (150) en un matériau transparent dont une face est plane et dont l'autre face est structurée et définit une pluralité de microlentilles ;
une pluralité de puces semiconductrices (100) comprenant chacune au moins une LED (120ᵣ, 120_{g}, 120_{b}), disposées sur la face plane de la plaque de support (150) ; et
un réseau de pistes conductrices d'interconnexion contactant les puces (100) par leur face opposée à la plaque de support (150),
dans lequel chaque puce (100) comprend un empilement de couches semiconductrices inorganiques (101) dans lequel est formée ladite au moins une LED (120ᵣ, 120_{g}, 120_{b}), et un circuit de commande (103) de ladite au moins une LED formé dans et sur un substrat semiconducteur, le circuit de commande (103) étant accolé à une face de l'empilement (101), et chaque puce (100) étant disposée de façon que la face de l'empilement (101) opposée au circuit de commande (103) soit tournée vers la plaque de support (150),
et dans lequel, dans chaque puce (100), le circuit de commande comprend une pluralité de bornes de connexion électrique (Vp, Vn, Vdata, Vsel) disposées sur la face du circuit de commande (103) opposée à l'empilement (101).

## Patentansprüche

1. Verfahren zur Herstellung einer LED-Anzeigevorrichtung, das die folgenden aufeinanderfolgenden Schritte aufweist:
a) Übertragen einer Vielzahl von Halbleiterchips (100), die jeweils mindestens eine LED (120ᵣ, 120_{g}, 120_{b}) aufweisen, auf eine ebene Oberfläche einer Trägerplatte (150) aus einem transparenten Material, deren andere Oberfläche strukturiert ist und eine Vielzahl von Mikrolinsen definiert; und
b) Bilden eines Netzwerks (130) aus leitenden Verbindungsbahnen, die die Chips (100) an ihrer der Trägerplatte (150) gegenüberliegenden Oberfläche kontaktieren
wobei jeder Chip (100) einen Stapel anorganischer Halbleiterschichten (101) mit der mindestens einen darin ausgebildeten LED (120ᵣ, 120_{g}, 120_{b}) und eine innerhalb und auf einem Halbleitersubstrat ausgebildete Schaltung (103) zum Steuern der mindestens einen LED aufweist, wobei die Steuerschaltung (103) an einer Oberfläche des Stapels (101) angeordnet ist und der Chip (100) so angeordnet ist, dass die der Steuerschaltung (103) gegenüberliegende Oberfläche des Stapels (101) der Trägerplatte (150) zugewandt ist,
und wobei in jedem Chip (100) die Steuerschaltung eine Vielzahl von elektrischen Verbindungsanschlüssen (Vp, Vn, Vdata, Vsel) aufweist, die auf der Oberfläche der Steuerschaltung (103) gegenüber dem Stapel (101) angeordnet sind.

2. Verfahren nach Anspruch 1, wobei im Schritt a) die Trägerplatte (150) mittels einer Lichtquelle beleuchtet wird, die auf der Seite ihrer strukturierten Oberfläche (150b) angeordnet ist, um auf ihrer ebenen Oberfläche (150a) ein Lichtmuster zu erzeugen, das als Ausrichtungsmarkierung für die Positionierung der Chips (100) auf der Trägerplatte (150) verwendet wird.

3. Verfahren nach Anspruch 1 oder 2, das ferner zwischen Schritt a) und Schritt b) einen Schritt c) das Abscheiden einer undurchsichtigen Harzschicht (121) zwischen den Chips (100) der Vorrichtung aufweist.

4. Verfahren nach Anspruch 3, wobei die Schicht (121) eine Negativ-Resistschicht ist, wobei Schritt c) die folgenden aufeinanderfolgenden Schritte aufweist::
Abscheiden der Schicht (121) zwischen den Chips (100) und auf der der Trägerplatte (150) gegenüberliegenden Oberfläche der Chips (100);
Beleuchten der Schicht (121) durch die Trägerplatte (150), wobei die Chips (100) während des Beleuchtungsschritts als Maske verwendet werden; und Entwickeln des Resists.

5. Verfahren nach Anspruch 4, wobei Schritt c) ferner einen Schritt des Annealen der Schicht (121) zwischen dem Beleuchtungsschritt und dem Entwicklungsschritt aufweist.

6. Verfahren nach einem der Ansprüche 1 bis 5, wobei jeder Chip (100) eine Vielzahl von in dem Stapel (101) ausgebildeten LEDs aufweist, wobei die Steuerschaltung (103) in der Lage ist, die verschiedenen LEDs des Chips individuell zu steuern.

7. Verfahren nach einem der Ansprüche 1 bis 6, wobei das Netzwerk (130) von leitenden Verbindungsbahnen mit den elektrischen Verbindungsanschlüssen (Vp, Vn, Vdata, Vsel) in Kontakt steht.

8. Verfahren nach Anspruch 7, wobei das Netzwerk (130) von leitenden Verbindungsbahnen durch Drucken einer ersten leitenden Ebene, gefolgt von einer isolierenden Ebene, gefolgt von einer zweiten leitenden Ebene, gebildet wird.

9. Eine LED-Anzeigevorrichtung, die Folgendes aufweist:
eine Trägerplatte (150) aus einem transparenten Material mit einer ebenen Oberfläche, deren andere Oberfläche strukturiert ist und eine Vielzahl von Mikrolinsen definiert;
eine Vielzahl von Halbleiterchips (100), die jeweils mindestens eine LED (120ᵣ, 120_{g}, 120_{b}) aufweisen und die auf der ebenen Oberfläche der Trägerplatte (150) angeordnet sind; und
ein Netzwerk von leitenden Verbindungsbahnen, die die Chips (100) an ihrer der Trägerplatte (150) gegenüberliegenden Oberfläche kontaktieren,
wobei jeder Chip (100) einen Stapel anorganischer Halbleiterschichten (101), in denen die mindestens eine LED (120ᵣ, 120_{g}, 120_{b}) ausgebildet ist, und eine Schaltung (103) zum Steuern der mindestens einen LED, die innerhalb und auf einem Halbleitersubstrat ausgebildet ist, aufweist, wobei die Steuerschaltung (103) an einer Oberfläche des Stapels (101) angeordnet ist und der Chip (100) so angeordnet ist, dass die der Steuerschaltung (103) gegenüberliegende Oberfläche des Stapels (101) der Trägerplatte (150) zugewandt ist,
und wobei in jedem Chip (100) die Steuerschaltung eine Vielzahl von elektrischen Verbindungsanschlüssen (Vp, Vn, Vdata, Vsel) aufweist, die auf der dem Stapel (101) gegenüberliegenden Oberfläche der Steuerschaltung (103) angeordnet sind.

## Claims

1. A method of manufacturing a LED display device, comprising the successive steps of:
a) transferring, onto a planar surface of a support plate (150) made of a transparent material having its other surface structured and defining a plurality of microlenses, a plurality of semiconductor chips (100), each comprising at least one LED (120ᵣ, 120_{g}, 120_{b}); and
b) forming a network (130) of conductive interconnection tracks contacting the chips (100) by their surface opposite to the support plate (150)
wherein each chip (100) comprises a stack of inorganic semiconductor layers (101) having said at least one LED (120ᵣ, 120_{g}, 120_{b}) formed therein, and a circuit (103) for controlling said at least one LED formed inside and on top of a semiconductor substrate, the control circuit (103) being placed against a surface of the stack (101), and said chip (100) being arranged so that the surface of the stack (101) opposite to the control circuit (103) faces the support plate (150),
and wherein, in each chip (100), the control circuit comprises a plurality of electric connection terminals (Vp, Vn, Vdata, Vsel) arranged on the surface of the control circuit (103) opposite to the stack (101).

2. The method according to claim 1, wherein during step a), the support plate (150) is illuminated by means of a light source arranged on the side of its structured surface (150b), to generate on its planar surface (150a) a light pattern used as an alignment mark for the positioning of the chips (100) on the support plate (150).

3. The method according to claim 1 or 2, further comprising, between step a) and step b), a step c) of deposition of an opaque resin layer (121) between the chips (100) of the device.

4. The method according to claim 3, wherein said layer (121) is a negative resist layer, step c) comprising the successive steps of:
depositing said layer (121) between the chips (100) and on the surface of the chips (100) opposite to the support plate (150);
illuminating said layer (121) through the support plate (150), the chips (100) being used as a mask during the illumination step; and
developing the resist.

5. The method according to claim 4, wherein step c) further comprises a step of annealing said layer (121) between the illumination step and the development step.

6. The method according to any of claims 1 to 5, wherein each chip (100) comprises a plurality of LEDs formed in said stack (101), the control circuit (103) being capable of individually controlling the different LEDs of the chip.

7. The method according to any of claims 1 to 6, wherein the network (130) of conductive interconnection tracks is in contact with said electric connection terminals (Vp, Vn, Vdata, Vsel).

8. The method according to claim 7, wherein the network (130) of conductive interconnection tracks is formed by printing of a first conductive level, followed by an insulating level, followed by a second conductive level.

9. A LED display device, comprising:
a support plate (150) made of a transparent material having a planar surface and having its other surface structured and defining a plurality of microlenses;
a plurality of semiconductor chips (100), each comprising at least one LED (120ᵣ, 120_{g}, 120_{b}), arranged on the planar surface of the support plate (150); and
a network of conductive interconnection tracks contacting the chips (100) by their surface opposite to the support plate (150),
wherein each chip (100) comprises a stack of inorganic semiconductor layers (101) having said at least one LED (120ᵣ, 120_{g}, 120_{b}) formed therein, and a circuit (103) for controlling said at least one LED formed inside and on top of a semiconductor substrate, the control circuit (103) being placed against a surface of the stack (101), and said chip (100) being arranged so that the surface of the stack (101) opposite to the control circuit (103) faces the support plate (150),
and wherein, in each chip (100), the control circuit comprises a plurality of electric connection terminals (Vp, Vn, Vdata, Vsel) arranged on the surface of the control circuit (103) opposite to the stack (101).
